# EUROPEAN PATENT APPLICATION

(11) **EP 0 546 685 A2**
(43) Date of publication of application: **16.06.1993**
(21) Application number: 92310248.7
(22) Date of filing: 10.11.1992
(51) Int. Cl.: H01L 21/00

(54) **Megasonic cleaning system**

(30) Priority: 12.11.1991 US 791094; 22.05.1992 US 886864
(71) Applicant: SUBMICRON SYSTEMS, INC., Allentown, PA 18106 (US)
(72) Inventor: Grant, Robert W., Excelsior MN 55331 (US); Novak, Richard E., Plymouth, MN 55447 (US)
(74) Representative: Parr, Ronald Edward R.E. Parr & Co.

(57) **Abstract**

Megasonic cleaning system for use in cleaning of electronic or other items such as semiconductor wafers or semiconductor substrates in a wafer carrier. Formed piezoelectric transducers are bonded to a tubular envelope at a low temperature and are excited at a first frequency or a second higher frequency for cleaning of items in a cleaning tank. A novel sealing assembly accommodates tubular envelopes of varying diameters.

## Description

The present invention relates to megasonic cleaning, in particular to megasonic cleaning apparatus (also referred to herein as megasonic cleaning system) and to methods of megasonic cleaning. The invention also relates to a process of bonding a piezoelectric transducer to a housing. Further, the present invention pertains to a megasonic cleaning tank, and more particularly, pertains to a tank using one, two or more megasonic frequencies for cleaning of items, such as wafer chips. A unique transducer assembly can be used to generate the energy.

Ultrasonic frequencies have been used for a long time to cause cavitation in cleaning solutions. These frequencies have been in the thousand kilohertz or low hundred thousand kilohertz ranges. In recent year, higher frequencies have been used to affect the cleaning efficiencies of smaller particles in the submicron range. The frequencies called "megasonic" are generally understood to be of the order of one megahertz. However, use of a single megasonic frequency has not proved to be a "cure" for cleaning objects where different sizes of contaminates or particulates are abundant.

Also, in the past piezoelectric devices have been silvered and secured by an epoxy resin (sometines referred to herein as "epoxy") onto a metal or quartz envelope. Epoxy bonding of a piezoelectric device to a sappire or quartz mount has not, however, proven to be a good method for the following reason. Bubbles in the epoxy which were present in set-up or during use impede the sonic wave propagation. This in turn causes areas of non-cleaning to occur. The epoxy is a poor heat conductor which in use allows the piezoelectric ceramic device to heat up, which reduces the power output of the system.

Until now, quartz lenses have been used to shape the waves emitting from the transducers into the process tank. These are expensive to grind, and are generally fragile. The prior art transducers have been generally flat, and mounted on a flat "window".

The present invention overcomes these deficiencies of the prior art. In a first aspect the invention provides a method of cleaning articles, for example semiconductor wafers and semiconductor substrates, which comprises immersing the articles in a cleaning fluid and applying to the fluid at least two megasonic emissions of different frequencies.

Apparatus suitable for use in the first aspect of the invention is megasonic cleaning apparatus comprising:
a. a tank;
b. a tube extending through a lower portion of said tank and means for securing said tube to opposing sides thereof; and
c. at least one piezoelectric transducer secured to an interior surface of said tube and between said opposing sides of said tank.

In a second aspect the invention provides a method of cleaning articles, for example semiconductor wafers and semiconductor substrates, using two or more piezoelectric transducers or other sources of megasonic emissions, the sources having substantially the same frequency and being in a tube or other housing having a thickness corresponding to a quarter wavelength (or multiple thereof) at the speed of sound.

Preferred forms of the invention have one or more of the following features:
(a) providing a method of exciting a piezoelectric device at two distinct frequencies to further improve the cleaning efficiency wherein particles of a smaller diameter are affected by higher or different frequenies;
(b) a process of low temperature bonding of piezoelectric transducers to an inert tube or other envelope without the need for the use of epoxy, which allows use in ultra-high purity cleaning applications giving greater cleaning reliability.

The general purpose of the present invention is to provide a megasonic cleaner. With reference to said first aspect of the invention, in preferred forms thereof formed piezoelectric ceramic transducers bonded by a low temperature process to a tubular envelope transmit megasonic waves using different frequencies to effect cleaning of items, such as semiconductor wafers or semiconductor substrates in a tank. A cylindrical envelope engages the walls of the tank and is sealed therein by a sealing assembly which includes an angled mounting collar.

According to one embodiment of the first aspect, a tubular envelope is secured in two sides of a cleaning tank. Alternating formed piezoelectric ceramic transducers are bonded in an N₂ environment to the inside of the tubular envelope and transmit megasonic waves at different frequencies. An angled mounting collar with a seal and O-rings seals the ends of the tubular envelope to the tank ends by means of a cap which exerts pressure thereupon to appropriately compress the O-rings to effect a seal.

In a preferred form of the second aspect of the invention, there is used a tubular-envelope having different sets of piezoelectric ceramic transducers, the tube having a thickness corresponding to a quarter wave length at the speed of sound. Each set of piezoelectric ceramic transducers is excited at the same frequency.

Significant features of preferred forms of the first aspect of the present invention are one or more of the following:
(a) a megasonic cleaner which uses two different megasonic frequencies;
   (b) piezoelectric ceramic transducers bonded in an N₂ environment to a tubular envelope by a low temperature method
   (c) the use of an angled mounting collar and O-rings to accommodate tubular envelopes of varying diameters.

Significant features of preferred forms of the second aspect of the present invention is the use of two natural frequencies surrounding the otherwise piezoelectric transducer natural frequency. When the 1/4 wave length thickness of window (tube wall) material having an acoustical impedance between that of the ceramic transducer and the liquid media is used, the window becomes part of the impedance system allowing for up to about 70% efficiency.

Having thus described the embodiments of the present invention, it is the principal object hereof to provide a megasonic cleaner.

One object of the present invention is unique mounting of the piezoelectric transducers for optimizing energy transfer.

There are now described, by way of example and with reference to the accompanying drawings, apparatus, methods and processes according to the present invention.

In the drawings:
FIG. 1 illustrates a side view in cross section of the megasonic cleaner including a tubular envelope, angled mounting collar and sealing assembly;
FIG. 2 illustrates an end view of the tubular envelope;
FIG. 3 illustrates an end view of the megasonic cleaner of Fig. 1, in cross section;
FIG. 4 illustrates a side view in cross section of the angled mounting collar;
FIG. 5 illustrates a side view in cross section of the sealing assembly;
FIG. 6, an alternative embodiment, illustrates a perspective view of a tubular envelope; and
FIG. 7 illustrates a cross-sectional view of the tubular envelope along line 7-7- of FIG. 6.

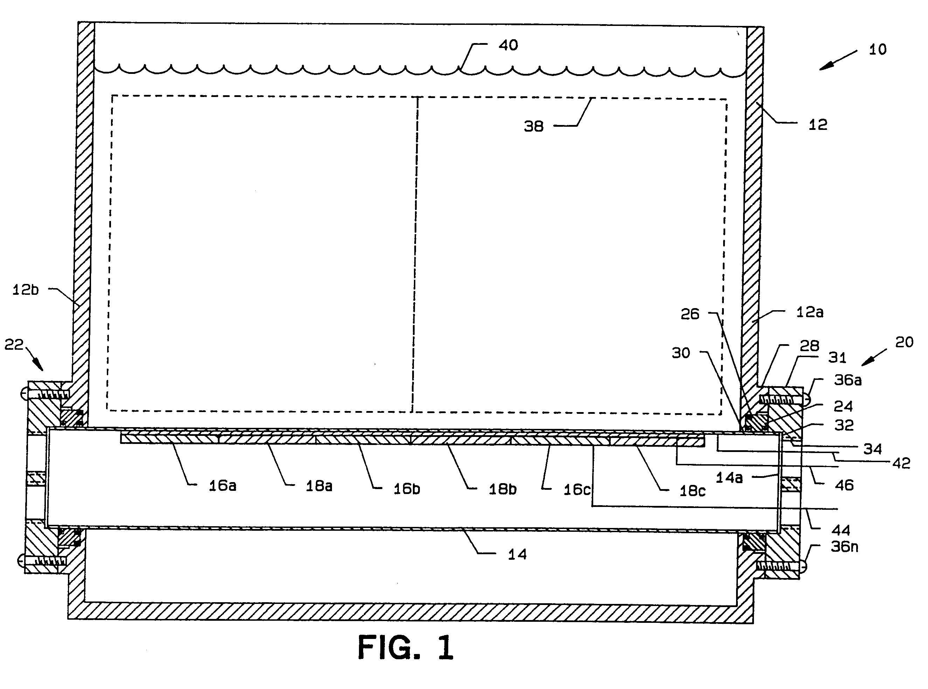

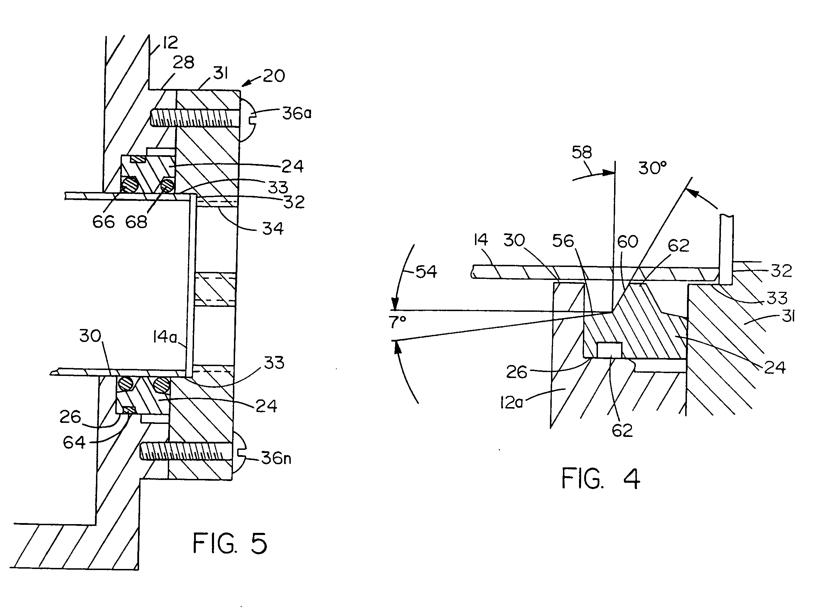

FIG. 1 illustrates a sectional view of a megasonic cleaner 10, the present invention, including a tank 12, a tubular envelope 14 engaged to and extending through the ends 12a and 12b of the tank 12, a plurality of staggered piezoelectric ceramic transducers 16a-16c and 18a-18c bonded to an upper interior surface of the tubular envelope 14. Like sealing assemblies 20 and 22 are aligned over and about the ends of the tubular ceramic envelope 14. Sealing assembly 20 includes an annular angled mounting collar 24 aligned in an annular recess 26 in the tank end 12a. An annular raised shoulder 28 protrudes from the tank end 12a and aligns concentrically with the recess 26 and also with an orifice 30 in the tank end 12a. A cap 31 has an annular shoulder 32, annular surface 33 and central concentric orifice 34 aligned over the end 14a of the tubular envelope 14 and also against the angled mounting collar 24. A plurality of fasteners 36a-36n secures the cap 31 to the annular raised shoulder 28. Seals and O-rings complete the seal and are described later in FIG. 5. A wafer carrier 38 is immersed in a semiconductor cleaning fluid 40.

Wire 42 secures electrically to the tubular ceramic envelope 14 and wires 44 and 46 secure electrically to the piezoelectric ceramic transducers 16a-16c and 18a-18c, respectively, for excitation and subsequent cleaning action on a multiple frequency basis through the semiconductor cleaning fluid 40. The piezoelectric ceramic transducers 16a-16c and 18a-18c operate in the area of 1.2 megahertz and .75 megahertz.

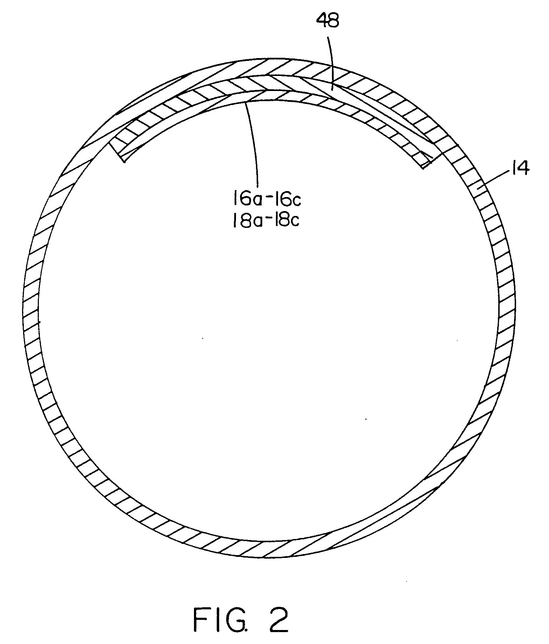

FIG. 2 illustrates an end view of the tubular envelope 14 in cross section including a general view of the piezoelectric ceramic transducers 16a-16c and 18a-18c where all numerals correspond to those elements previously described. The method of bonding of the piezoelectric ceramic transducers 16a-16c and 18a-18c to the tubular envelope 14 takes advantage of the fact that the transducer material has a critical temperature of about 350°C to 650°C (a de-poling temperature) which must not be approached. A bonding procedure which does not exceed 250°C is used in the mounting procedure. In order to use a metal to ceramic mounting procedure, which will eliminate the mentioned faults in the older prior art epoxy mounting method, a low temperature brazing alloy is used to bond between the silvered piezoelectric ceramic transducers 16a-16c and 18a-18c and the metalized surface of the inside diameter of the tubular envelope 14, which can be ceramic or sapphire. This solder 48 is a pre-formed 96.5% tin, 3.5% silver, and melts at about 221°C. This solder 48 sticks to both the silver and the silver/tungsten, which is fired onto the inside of the tubular envelope 14. The solder 48 is applied to a .01 inch thickness. This is further "fluxed" with a nickel chloride or a rosin-based flux. The firing of the tubular envelope metalization is performed first. This firing step is done at about 1300°C, and does not affect the piezoelectric ceramic transducers 16a-16c and 18a-18c since the transducers are not yet attached. The final attachment of the piezoelectric ceramic transducers 16a-16c and 18a-18c to the inside of the tubular envelope 14 takes place in a furnace at 230°C which is carefully controlled to preserve the electrical piezoelectric ceramic transducers 16a-16c and 18a-18c and the mechanical integrity of the tubular envelope 14 (e.g., cracking).

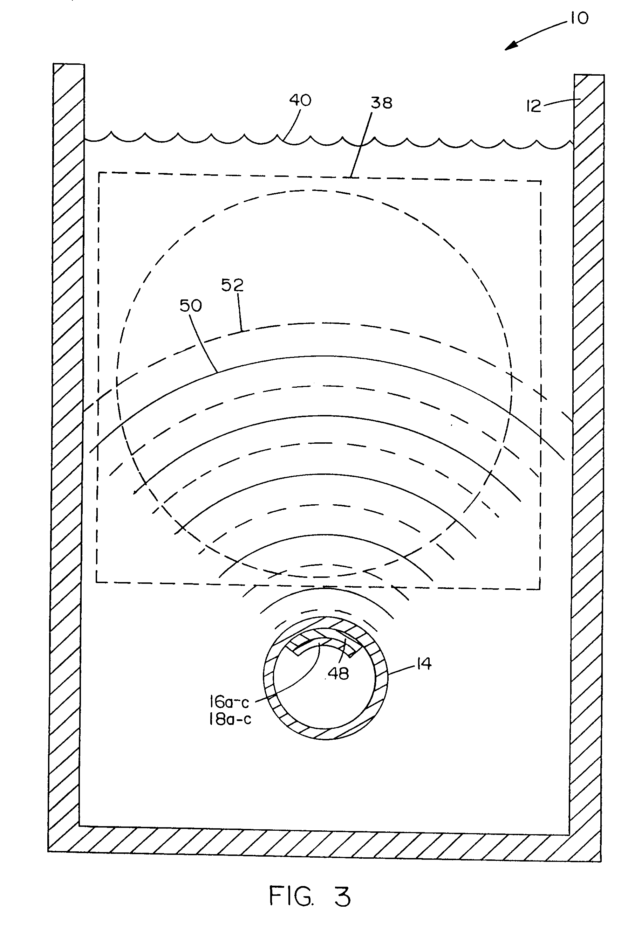

FIG. 3 illustrates an end view of the megasonic cleaner 10 in cross section where all numerals correspond to those elements previously described. The piezoelectric transducers provide a method of producing diverging longitudinal sound waves without the use of lenses or reflectors, as is now described. The present invention includes a cylindrically shaped transducer including piezoelectric ceramic transducers 16a-16c and 18a-18c to radiate a longitudinal wave in a diverging cylindrical shape illustrated by megasonic waves 50 and 52. The divergence angle is naturally determined by the degree of arc used in the piezoelectric ceramic transducers 16a-16c and 18a-18c. The piezoelectric ceramic transducers 16a-16c and 18a-18c are formed or ground into a cylindrically shaped piece, measuring approximately 90° of an arc, and then fired, metalized and electrically "poled" or oriented into a radial direction for its intended use. Different shapes are naturally made for the sonar field, and not for use in this physical work of the megasonics application until modified according to the teachings of this patent. A radiation pattern of a formed 90° angle is used in this megasonics application, and cover a wafer cassette 18 including a plurality of wafers, as shown in the illustration. The piezoelectric ceramic transducers 16a-16c and 18a-18c produce a frequency of 1.21 MHZ as illustrated by megasonic wave 50, and piezoelectric ceramic transducers 16a-16c and 18a-18c can also produce a frequency of .72 MHZ when excited at a lower frequency as illustrated by the megasonic wave 52. By using sapphire, an inert tubular envelope 14 for the megasonic transducer 10 can be formed via a metalization technique, which can be used to transmit megasonic frequency energy to virtually all semiconductor cleaning fluids such as HF, HCI, NH₄OH, HNO₃, H₂SO₄ and others.

FIG. 4 illustrates a side view in cross section of the angled mounting collar 24 where all numerals correspond to those elements previously described. The annular angled mounting collar 24 includes an angle 54 of 7° angled between a surface 56, and a horizontal angle 58 of 30° between surface 60 and the vertical which equals a total included angle of 127° between the surfaces 56 and 60. An O-ring fits between the surfaces 56 and 60, the tubular envelope 14 and the bottom of the recess 26 as illustrated in FIG. 5. The corresponding angles on the other side of the annular ridge are the same as just described. An annular groove 62 accommodates a seal 64 as illustrated in FIG. 5. The angles 54 and 58 are described as 7° and 30°, but may be any appropriate angle as desired to promote sealing of the O-rings. The recited angles are not to be construed as limiting of the scope of the present invention.

FIG. 5 illustrates a side view in cross section of the sealing assembly 20 where all numerals correspond to those elements previously described. Illustrated in particular is the squeezing and positioning of the O-rings 66 and 68 by the angled mounting collar 24, thus effecting a seal for tubes of various diameters. It is appreciated that O-rings of various thicknesses can be used for accommodation of different sized envelope tubes 14, i.e., a smaller envelope tube 14 would require larger O-rings which would bridge the gap between the surfaces of the angled mounting collar 24 and the envelope tube 14, as well as the wall 12a.

### MODE OF OPERATION

The method of mounting the tubular envelope 14 in the process tank 12 accommodates the grown diameter of the envelope tube 14. This ensures a simple assembly onto virtually any tank. The illustration of an O-ring sealing assembly shows how to mount the sapphire or quartz tubular envelope 14 through the tank 12. The angled mounting collar 24 squeezes the two O-rings 66 and 68 resulting in a radius reducing contact. Since a sapphire tubular envelope 14 is single crystal grown, and often varies by +/- .01 inch, it is necessary to accommodate this variation with this non-standard O-ring squeeze technique.

### DESCRIPTION OF AN ALTERNATIVE EMBODIMENT

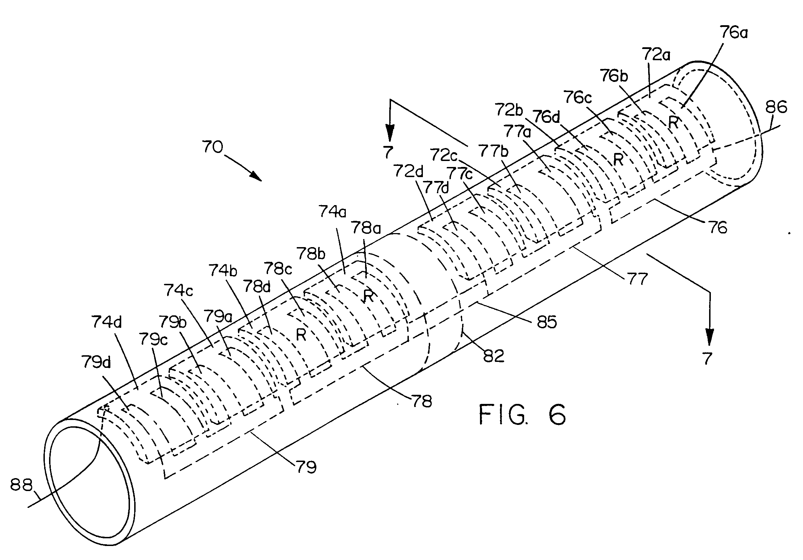

FIG. 6, an alternative embodiment, illustrates a perspective view of a tubular envelope 70, for example of quartz or sapphire for incorporation into the megasonic cleaner 10 of FIG. 1. Groups of piezoelectric ceramic transducers, including a plurality of transducers 72a-72d and 74a-74d, are bonded as previously described to the upper interior surface of the tubular envelope 70. Spring bronze contactor bars 76, 78, and 79, having contactor fingers 76a-76d, 78a-78d, and 79a-79d, respectively, extend in pairs from the contactor bars 76-79 to springingly engage and provide sufficient electrical contact with the piezoelectric ceramic transducers 72a-72d and 74a-74d, The use of more than one contactor finger with each contactor bar allows sufficient power to be carried and transferred. A bus bar 85 connects the spring bronze contactor bars 77 and 78. The "R" designates reverse polarity of the transducers providing for in-phase transmitting of the energy. In one embodiment, every other pair of transducers is poled in reverse so that the transducers work in phase with each other; that is, + convex - two, + concave - two, and continuing in phase so that the transducers expand with each. The quartz tube is formed over a graphite mandrel, then machined to an exact one-quarter wavelength thickness, and then reflared to a smooth surface. Other frequencies can be utilized so long as the one-quarter wavelength frequency is utilized for the center (artificial) frequency.

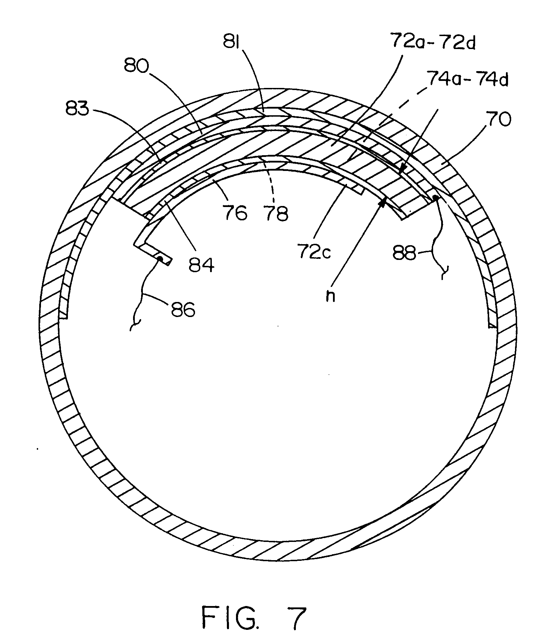

FIG. 7 illustrates a cross-sectional view along line 7-7 of FIG. 6 where all numerals correspond to those elements previously described. The transducers 72a-72d and 74a-74d are bonded to the tubular envelope 70 as previously described (and/or with a layer of conducting epoxy 80)as illustrated. A layer of silver metalization 81, for example, is deposited as previously described to the arcuate interior surface of the tubular envelope 70 with the exception of a separation band 82 illustrated in FIG. 6. A similar layer of metalization 83 is deposited on the larger radius surface of the transducers 72a-72d and 74a-74d, as well as another layer of metalization 84 deposited on the lesser radius surface of the transducers 72a-72d and 74a-74d. Thus, the layers are layered firstly beginning with a tubular envelope 70 followed by a metalization layer 81, a conductive epoxy 80, a metalization layer 83, transducers 72a-72d and 74a-74d, a metalization layer 84, and finally by contactor fingers 76a-76d, 77a-77d, 78a-78d, and 79a-79d of the contactor bars 76-79. In one alternative, the transducers can also be soldered to the coating on the quartz tube. The transducers 72a-72d and 74a-74d are shaped as 90° arcs for purposes of illustration only and not to be construed as limiting of the present invention. Each tube for the' transducers has a thickness"n" where the thickness is a quarter wave length of the excitation frequency used and can also be in multiples of the 1/4 wave length beginning at half wave multiple, such as 3/4 wave, 1 1/4 wave, etc. Impedance matching is accomplished by the inherent matching properties of quarter wave length thickness of the tube and usually require no matching devices to couple the megasonic excitation power amplifier to the radiating transducers 72a-72d and 74a-74d. The elimination of any intervening impedance matching devices allows an operating efficiency of up to 70%. An exciter lead 86 attaches to the contactor bar 76 and another exciter lead 88 attaches to the conducting epoxy 80. The transducers 72a-72d and 74a-74d are excited at a frequency, for example of either .8 KHZ or 1.1 KHZ. Certain debris is sensitive to different frequency excitation, and the excitation frequencies can be alternated between, for example .72 KHZ and 1.23 KHZ to accommodate different cleaning requirements, or in the alternative, one set of transducer such as transducers 72a-72d can be excited at, for example .8 KHZ and the other set of transducers 74a-74d can be excited at, for example 1.1 KHZ.

### MODE OF OPERATION OF THE ALTERNATIVE EMBODIMENT

With reference to FIGS. 6 and 7, megasonic excitation power is delivered through lead 88 which connects to the conducting epoxy 80 area contacting the transducers 74a-74d in common, and is then transferred through and exciting the transducers 74a-74d, to the spring contactors 79a-79d and 78a-768d connected to the contactor bars 78 and 79, thence via the bus bar 85 to the contactor bar 77, through fingers 77a-77d, through the transducers 72c and 72d and to the conducting epoxy area 80 to the right of the separation band 82, thus exciting transducers 72c and 72d. Power then flows through the common conductive epoxy area to the right of the separation band 82, through transducers 72a and 72b, thus exciting them, then through contactor fingers 76a-76d to the contactor bar 76 and through the lead 86 back to an excitation generator.

Various modifications can be made to the present invention without departing from the apparent scope hereof.

In preferred forms of the invention the tube is of sapphire or quartz. The apparatus can include means for radiating longitudinal waves in a diverging cylindrical configuration.

In the form of apparatus that includes finger means there can be for example be two, three or four fingers for each piezoelectric transducer.

In a preferred form of the method of the invention there are used two frequencies: one in the range 0.75 to 2 MHZ (for example 1 to 1.5 MHZ) and a second in the range 0.5 to 1.5 MHZ (for example 0.6 to 1 MHZ).
- 10: megasonic cleaner
- 12: tank
- 12a: tank end
- 12b: tank end
- 14: tubular envelope
- 14a: tube end
- 16a-c: piezoelectric ceramic transducers
- 18a-c: piezoelectric ceramic transducers
- 20: sealing assembly
- 22: sealing assembly
- 24: angled mounting collar
- 26: recess
- 28: annular raised shoulder
- 30: orifice
- 31: cap
- 32: annular shoulder
- 33: annular shoulder
- 34: central orifice
- 36a-n: fasteners
- 38: wafer carrier
- 40: semiconductor cleaning fluid
- 42: wire
- 44: wire
- 46: wire
- 48: solder
- 50: megasonic wave
- 52: megasonic wave
- 54: angle
- 56: surface
- 58: angle
- 60: surface
- 62: annular groove
- 64: seal
- 66: O-ring
- 68: O-ring
- 70: tubular envelope
- 72a-72n: transducers
- 74a-74n: transducers
- 76: contactor bar
- 78: contactor bar
- 76a-n: contactor fingers
- 78a-n: contactor fingers
- 80: conducting epoxy
- 81: metalizatlon
- 82: separation band
- 83: metalization
- 84: metalization
- 86: exciter lead
- 88: exciter lead

## Claims

1. A megasonic cleaning apparatus comprising:
a. a tank (12);
b. a tube (14) extending through a lower portion of said tank and means (20,22) for securing said tube to opposing sides thereof; and
c. at least one piezoelectric transducer (16a) secured to an interior surface of said tube and between said opposing sides of said tank.

2. Apparatus for megasonic cleaning of semiconductor wafers or semiconductor substrates using a cleaning fluid, said apparatus comprising:
a tank (12) to hold the fluid;
a tube (14) extending between opposed walls of the tank and secured at its respective end portions to said walls; and
at least one source (16a) of megasonic emission secured inside the tube.

3. Apparatus according to Claim 2, wherein said at least one source of megasonic emission comprises two transducers (16a, 18a) adapted, respectively, to produce megasonic waves of different frequencies.

4. Apparatus according to Claim 3, wherein said two different frequencies are respectively in the ranges 0.75 to 2 MHZ and 0.5 to 1.5 MHZ.

5. A megasonic cleaning apparatus comprising:
a. a tank (12);
b. a tube (14) extending through a lower portion of said tank and means (20, 22) for securing said tube to opposing sides thereof and having a thickness of at least one wave length of an operating frequency; and
c. at least one piezoelectric transducer (72a) secured to an interior surface of said tube and between said opposing sides of said tank and contacted by a finger means (76a-n).

6. Apparatus according to Claim 5, which includes a plurality of piezoelectric transducers connected in a series-parallel configuration by said finger means.

7. Apparatus according to Claim 5 to 6, which includes a predetermined plurality of piezoelectric transducers connected in a series-parallel configuration by said finger means to impedance match to a rf generator.

8. A megasonic cleaning apparatus which comprises:
a. a tank;
b. a tube extending through a lower portion of said tank and means for securing said tube to opposing sides thereof and having a thickness of at least one wave length of an operating frequency;
c. a plurality of piezoelectric transducers secured to an interior surface of said tube and between said opposing sides of said tank;
and
d. finger means connecting rf power from an rf generator to said piezoelectric transducers.

9. A method of cleaning articles, which comprises immersing the articles in a cleaning fluid and applying to the fluid at least two megasonic emissions of different frequencies.

10. A process of bonding a piezoelectric transducer to a sapphire tube comprising the steps of:
a. applying a low temperature solder to an interior surface of the tube;
b. firing the solder and a flux to said tube at a higher temperature; and
c. joining a piezoelectric transducer to said tube at a lower temperature.
